(19) Europäisches Patentamt
European Patent Office
Office européen des brevets

(11) **EP 4 339 632 A1**

(12) **EUROPEAN PATENT APPLICATION**

(43) Date of publication:
**20.03.2024 Bulletin 2024/12**

(21) Application number: **22306370.2**

(22) Date of filing: **19.09.2022**

(51) International Patent Classification (IPC):
**G01R 31/367** (2019.01)

(52) Cooperative Patent Classification (CPC):
**G01R 31/367**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Tiamat**
**80000 Amiens (FR)**

(72) Inventor: **EL MEJDOUBI, Asmae**
**80080 AMIENS (FR)**

(74) Representative: **IPAZ**
**16, rue Gaillon**
**75002 Paris (FR)**

(54) **METHOD FOR DETERMINING A STATE OF CHARGE (SOC) OF A BATTERY**

(57) Method for determining a state of charge (SOC) of a battery, the method comprising the following steps:
- receiving at least one parameter corresponding to a percentage of an initial state of charge of the battery (1) based on at least one off-load voltage value and according to an open circuit voltage (OCV) - state of charge (SOC) function pace zone, the OCV-SOC function pace being separated into at least two zones,

- based on the at least one received parameter and at least two distinct models, determining for each model (2 and 3), at least one estimation of a state of charge and at least one output voltage value,
- providing an estimation of the state of charge of the battery based on the determined state of charge having the lowest error rate (4).

[Fig. 3]

**Description**

**Technical field**

The present invention relates to a method for determining a state of charge (SOC) of a battery. It also concerns a system for determining a state of charge (SOC) of a battery.

**Prior art**

The sodium-ion batteries lifetime and safety are very important for the real application. However, the optimal energy utilization and minimization of the degradation effects are among the typical challenges to be faced. With the challenges of safety management, charging and discharging control, performance degradation of the sodium-ion battery, and capacity fade, state of charge and state of health estimations have become a hotspot and a challenging issue. In fact, the design and implementation of a diagnosis models are considered as a key to deal with the problem of battery durability. The deployment of a diagnosis solution allows to anticipate and avoid failures, evaluate the state of health, estimate the state of charge and, based on such information, it becomes possible to envision control and/or maintenance actions to ensure the continuity of the battery's operation. However, the different batteries states, such as state of charge and state of health are not directly observable, which requires estimation and prediction algorithms, such as diagnosis and prognosis.

State of health is an important aspect in battery management systems (BMS) since it is considered as lifetime gauge. Therefore, a bad state of health estimation ultimately results in damaging the battery and reducing its lifespan. Like other chemical-based energy storage systems, the battery's use generates irreversible physical and chemical changes, and hence its performance tends to deteriorate gradually over its lifetime. Several aging protocols have been tested for sodium-ion battery aging, calendar and cycling aging, and show an internal resistance increase and a capacity decrease. Therefore, the definition of the end of life of the battery depends on these aging indicators, capacity and resistance, the same degradation as the lithium-ion batteries. However, these aging indicators are not measurable, so the main way to follow the battery aging online without interrupting the system is to estimate these indicators using diagnosis model.

The purpose of the present invention is to solve at least one of these disadvantages.

**Statement of the invention**

This goal is achieved with a method for determining a state of charge (SOC) of a battery, the method comprising the following steps:

- receiving at least one parameter corresponding to a percentage of an initial state of charge of the battery based on at least one off-load voltage value and according to an open circuit voltage (OCV) - state of charge (SOC) function pace zone, the OCV-SOC function pace being separated into at least two zones,
- based on the at least one received parameter and at least two distinct models, determining for each model, at least one estimation of a state of charge and at least one output voltage value,
- providing an estimation of the state of charge of the battery based on the determined state of charge having the lowest error rate.

The method of the present invention permits to determinate a state of charge (SOC) of a battery. The state of charge is defined as a percentage of the total capacity and it is used to reflect the battery performance. The OCV-SOC function is defined by volt values of the open circuit voltage (OCV) versus percentage values of the state of charge (SOC).

The batteries referred to by said method are batteries whose OCV-SOC function are not linear, i.e. OCV-SOC function comprises at least two "plateaus". The term "plateau" means the fact that the function comprises two zones of distinct curves following two different affine functions. For example, for:

- $Na_3V_2(PO_4)_2F_3$
- $Na_2CoFe(CN)_6$
- $Na_{0.6}Ni_{0.22}Al_{0.11}Mn_{0.66}O_2$
- $Na_{0.6}Ni_{0.45}Zn_{0.05}Mn_{0.4}Ti_{0.1}O_2$
- $R-Na_{1.92}Fe[Fe(CN)_6$
- $Na_2VTi(PO_4)_3$
- $P_2-Na_{2/3}Ni_{1/3}Mn_{2/3}O_2$

Moreover, the at least two models are used in parallel to estimate the state of charge. This gives a good accuracy for the state of charge estimation. Each model estimates well the state of charge in particular zone of the state of charge. The at least two models are compiled in parallel, the one with the lowest voltage estimation gives the state of charge with low accuracy. The comparison of the at least two error rates permits to choose the estimation the most accurate.

The step of receiving at least one parameter may comprise the following steps :

- receiving at least one off-load voltage value,
- partitioning of the OCV-SOC function in at least two zones, each zone having a distinct function,
- determining to which zone the at least one off-load voltage value belongs,
- providing the percentage of an initial state of charge of the battery from the function according to the said zone.

This step makes it possible to give a first estimation of the state of charge as a function of an OCV-SOC function curve zone. This first estimation given as a function of said zone is more accurate than an estimation as a function of the entire curve. Indeed, this makes it possible to further limit the error rate when calculating the state of charge.

For the at least two zones of the OCV-SOC function, a first zone may be set to 0 to 3.5 volts and a second zone may be set to 3.5 V to 4.5 volts. These values correspond to the OCV values in the OCV - SOC function.

The at least two zones are defined according to either a value of tension or according to a percentage of state of charge. Here, the threshold dividing the curve of the OCV-SOC function into at least two zones is 3.5 volts (OCV value) or 40% (value of state of charge). This separation occurs before the second plateau defined as above.

The first of the at least two distinct models may use an observer.

The used observer may be a Kalman filter.

The Kalman filter is used to estimate the state variables of a continuous nonlinear system that is linearized around its equilibrium point and is expressed using state functions. The Kalman filter gives better estimation in linear parts of the open circuit voltage, from 0 to 35% and from 45% to 100%.

The first of the at least two distinct models may use a sliding mode observer.

The first of the at least two distinct models may use an adaptive observer.

The second of the at least two distinct models may use a counting function. The state of charge estimation from 35% to 45% is difficult. So, in addition to the estimation using the state functions and the observer, an extra verification of the state of charge estimation has been add using the Coulomb Counting.

The state of charge may be updated at each iteration of the at least two models.

Therefore, the estimation of state of charge is updated at each iteration.

Following yet another aspect of the invention, it is proposed a system for determining a state of charge (SOC) of a battery, the system comprising:- a calculation module;

- one or more processors;
- one or more computer-readable media storing instructions that, when executed by the one or more processors, cause the system to:
- receive at least one parameter corresponding to a percentage of an initial state of charge of the battery based on at least one off-load voltage value and according to an open circuit voltage (OCV) - state of charge (SOC) function pace zone, the OCV-SOC function pace being separated into at least two zones,
- based on the at least one received parameter and at least two distinct models, determine for each model, at least one estimation of a state of charge and at least one output voltage value,
- provide an estimation of the state of charge of the battery based on the determined state of charge having the lowest error rate.

The system is named "state of charge module" and is configured to estimate and/or calculate the state of charge of the battery.

The one or more computer-readable media may be configured to:

- receive at least one off-load voltage value,
- cut of the OCV-SOC function in at least two zones, each zone having a distinct function,
- determine to which zone the at least one off-load voltage value belongs,
- provide the percentage of an initial state of charge of the battery from the function according to the said zone.

For the at least two zones of the OCV-SOC function, a first zone may be set to 0 to 3.5 volts and a second zone is set to 3.5 V to 4.5 volts.

The first of the at least two distinct models may use an observer.

The used observer may be a Kalman filter.

The first of the at least two distinct models may use a sliding mode observer.

The first of the at least two distinct models may use an adaptive observer.

The second of the at least two distinct models may use a counting function.

The used counting function may be a coulomb counting.

The one or more computer-readable media may be configured to update the state of charge at each iteration of the at least two models.

Following yet another aspect of the invention, it is proposed one or more non-transitory computer-readable media storing instructions that, when executed by one or more processors, cause a system to execute a method for determining a state of charge (SOC) of a battery, comprising the following steps:

- receiving at least one parameter corresponding to a percentage of an initial state of charge of the battery based on at least one off-load voltage value and according to an open circuit voltage (OCV) - state of charge (SOC) function pace zone, the OCV-SOC function pace being separated into at least two zones,
- based on the at least one received parameter and at least two distinct models, determining for each model, at least one estimation of a state of charge and at least one output voltage value,
- providing an estimation of the state of charge of the battery based on the determined state of charge having the lowest error rate.

**Description of the figures and embodiments**

Other advantages and particularities of the invention will appear from reading the detailed description of implementations and embodiments in no way limiting, and the following annexed drawings:

[Fig.1] illustrates a battery management system (BMS) according to the invention.
[Fig.2] describes a computational model according to the invention.
[Fig.3] illustrates model of the SOC module according to the invention.
[Fig.4a] describes a curve of an OVC-SOC function for Lithium-ion NMC.
[Fig.4b] describes a curve of an OVC-SOC function for Lithium-ion LFP.
[Fig.5] describes a curve of an OVC-SOC function for Sodium-ion NVPF-HC($(Na_3V_2(PO_4)_2F_3)$-(Hard Carbon)).
[Fig.6] describes a model using a Kalman filter according to the invention.
[Fig.7] describes a model using a Coulomb Counting according to the invention.
[Fig.8a] describes an NVPF-HC electrical model according to the invention.
[Fig.8b] describes the electrical circuit with the electrochemical impedance spectroscopy (EIS) test results.

These embodiments being in no way limiting, one may in particular consider variants of the invention comprising only a selection of characteristics described or illustrated subsequently isolated from the other characteristics described or illustrated (even if this selection is isolated within a sentence comprising these other characteristics), if this selection of characteristics is sufficient to confer a technical advantage or to differentiate the invention from the state of the previous technique. This selection includes at least one feature of functional preference without structural details, and / or with only part of the structural details if this part alone is sufficient to confer a technical advantage or to differentiate the invention from the prior art.

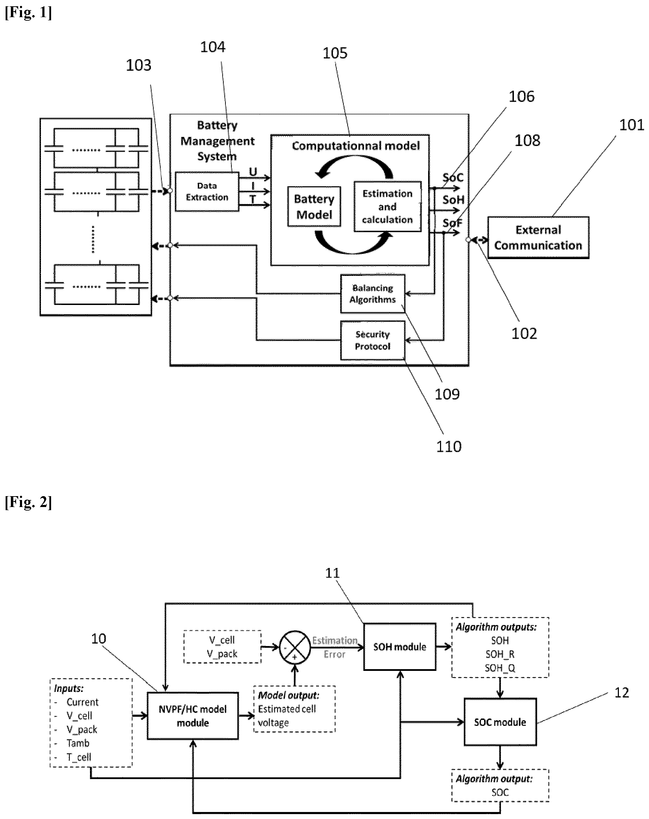

We will first describe, with reference to figure 1, a battery management system (BMS). In a typical sodium-ion battery implemented in real application, coupled to the external communication 101, is the communication link 102. Communication link 102 may be used to obtain configuration updates from an external data source and communicate to the user the different information concerning the sodium-ion battery as: the state of health, the state of charge and the state of function.

Communication link 103 may be used to provide the communication between each cell modules and the battery management system. The data extraction 104 can read the different data measured. Using these data, the computational model 105 calculates the state of charge. The computational model 105 comprises a battery model and an estimation and calculation module. The output state of charge is communicated to the balancing algorithms 109 using the communication link 106. This balancing algorithm 109 allows the balancing of the different sodium-ion cells module. Cells module balancing is a way of compensating for these weaker cells by equalizing the charge on all the cells modules in the chain, thus extending the battery lifetime. The lifetime of the sodium-ion battery can be extended using a good balancing algorithm 109.

The sodium-ion batteries have an important advantageous compared to the other technologies. The sodium-ion batteries can be discharged completely until 0V. In case of abnormal event, the security protocol 110 is activated using the communication link 108. The security protocol 110 controls also the semi-conductor devices, and in this case, the semi-conductor devices discharge completely all the cells or all the battery to achieve 0V. So, the cells polarities don't present any potential. In this way, the battery can be disassembled and transported safely. We note that even if in case of fault alert, the sodium-ion battery will be charged normally without problem.

Using the proposed technology to monitor the different cells of sodium-ion battery, the detection of aged cell or a thermal runaway event becomes easy, which helps in the preventive maintenance.

According to the figure 2, the computational model 105 contains:

- The NVPF/HC ($(Na_3V_2(PO_4)_2F_3)$-(Hard Carbon)) model module 10: the cell model to estimate the cell voltage based on the measurement of current and temperature.

    - a state of health (SOH) module 11 to estimate the different parameters of the state of health of the pack battery based on the measurements and the voltage estimation error.
    - a state of charge (SOC) module 12 to estimate the state of charge based on the measurements and the state of health parameters.

The input parameters of the The NVPF/HC model module 10 are: Vcell that corresponds to the cell voltage, Tcell that corresponds to the cell surface temperature and Tamb that corresponds to the operating temperature. Moreover, V_pack corresponds to the voltage of all battery pack, SOH_R corresponds to the state of health based on the resistance and SOH Q corresponds to the state of health based on the capacity

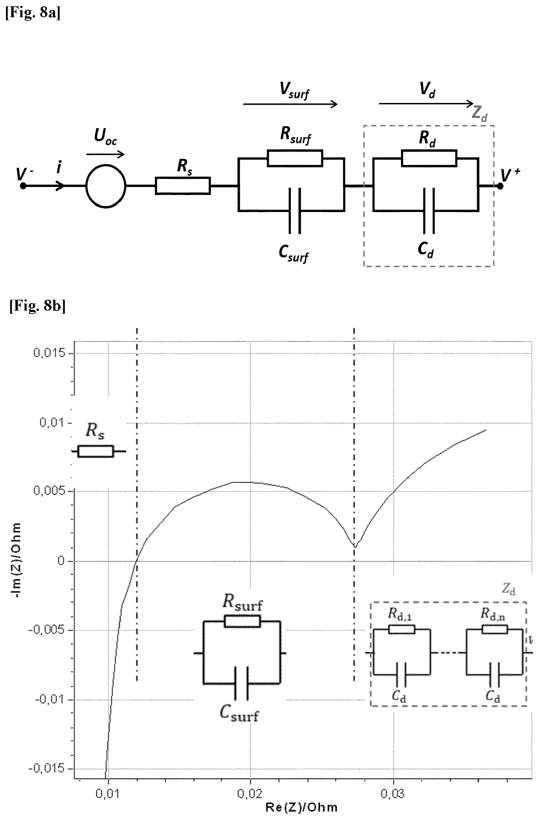

Based on the measurements of current, operating temperature and the open circuit voltage (the voltage just before connecting the cell to a load or a charger, the NVPF-HC model module 10 estimates the cell voltage. The NVPF-HC model module 10 is based on RC circuit as presented figure 8a.

Uoc is the open circuit voltage. i is the current (positive for charge, negative for discharge). V- is the battery negative terminal. V+ is the battery positive terminal. Rs is the equivalent series resistance, representing all the ohmic contributions of the cell (contact resistances, migration of electrons in the current collectors and the electrode, migration of ions in the electrolyte). Rsurf is the surface resistance, which corresponds to the voltage drop at the interface between the particles of active material and the electrolyte. This parameter is linked to the charge transfers of the two electrodes and to any passivation layers present on their surfaces. Csurf corresponds to the "surface time constant" $\tau surf$ = *Rsurf* $\times$ *Csurf* which is used to approximate the rapid dynamics (often less than a second) linked to the interface phenomena of the two electrodes (charge transfers, double layer capacitance, possibly dynamics linked to passivation layers with capacitive and / or diffusive effects). Vsurf is the voltage across the RsurfCsurf circuit. Zd is the diffusion impedance which groups together the overvoltages linked to the phenomena of diffusion of atoms in the active material particles of each electrode and diffusion of ions in the electrolyte. Vd is the voltage across the impedance Zd.

$$V_{cell} = V^+ - V^-$$

$$\dot{V}_{surf} = \frac{1}{R_{surf}.C_{surf}}.V_{surf} - \frac{1}{C_{surf}}.iV_d = Z_d.i$$

$$V_{cell} = U_{OC} + R_s.i + V_{surf} + V_d$$

The open circuit voltage depends on the state of charge, temperature and operating phases (charge or discharge). Based on the values of the open circuit voltage and the operating temperature, a parameter is specified. The parameter corresponds to the initial state of charge (SOC0) is specified. This initial value is important for the state of charge estimation and is considered as an input of the state of charge estimation module. The results of the state of charge estimation are inputs of the model. At each iteration, the estimated state of charge combined to the operating temperature, is used to calculate the open circuit voltage.

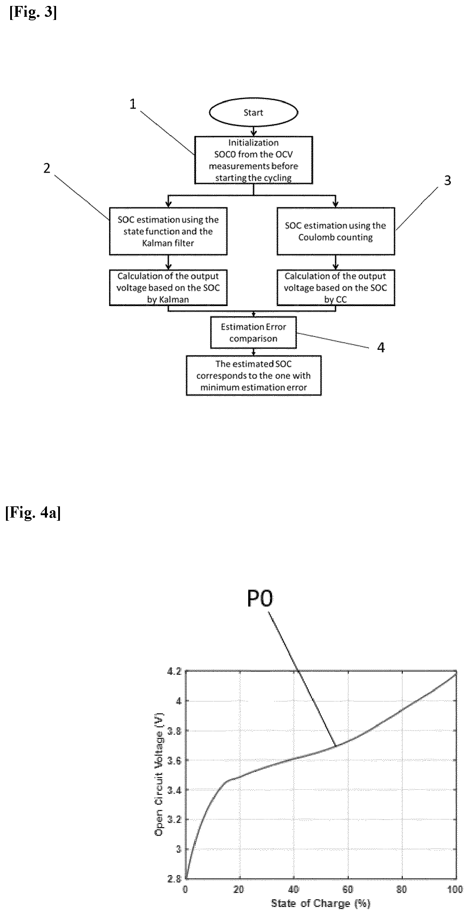

With reference to figure 3, the model of the SOC module 12 according to the invention is described. In this embodiment, the battery is a sodium-ion NVPF-HC battery. The method is applied by the module of the state of charge 12. The method comprises the following steps:

- receiving at least one parameter corresponding to a percentage of an initial state of charge of the battery (1) based on at least one off-load voltage value and according to an open circuit voltage (OCV) - state of charge (SOC) function pace zone, the OCV-SOC function pace being separated into at least two zones,
- based on the at least one received parameter and at least two distinct models, determining for each model (2 and 3), at least one estimation of a state of charge and at least one output voltage value,

- providing an estimation of the state of charge of the battery based on the determined state of charge having the lowest error rate (4).

The state of charge (SOC) is the level of charge of the battery compared to its capacity. Its formula is as follows:

$$SOC(t) = SOC_0 + \int_{t_0}^{t} \frac{\eta . i(t)}{Q} dt$$

$$SOC_k = SOC_{k-1} + \frac{\eta . dt}{Q} . i_k$$

$\eta$ is the Coulomb coefficient, i(t) is the current (positive for charge, negative for discharge), $SOC_0$ is a percentage of an initial state of charge of the battery. Q is considered as the available capacity in the actual battery at a given aging condition. As such, Q is updated after each diagnosis process and taken to be equal to the real capacity provided by the battery at each charge/discharge measurement. The capacity also decreases as the battery ages.

Based on the NVPF-HC electrical model of the figure 8a, we have :

$$\dot{V}_{surf} = \frac{1}{R_{surf} . C_{surf}} . V_{surf} - \frac{1}{C_{surf}} . i$$

And, the battery voltage is

$$V_{cell} = U_{OC} + R_s . i + V_{surf} + V_d$$

In the battery voltage equation, we can measure only the battery voltage Vcell and the current i. The parameters of the resistor capacitor (RC) circuit ($R_s$, $R_{surf}$, $C_{surf}$ and $Z_d$) are determined using electrochemical impedance spectroscopy (EIS) (presented in Fig. 8b) and galvanostatic intermittent titration technical (GITT) tests at different state of charge and temperature. This phase corresponds to the calibration phase of the method in the beginning of life of the battery. These data are the initial data, even they are not precise, at each iteration of the method these data will be updated. Thus, the cell model will converge to the measurement voltage value and the error will decrease to achieve the possible minimum value. So in the voltage equation $V_{cell}$, the last parameter to define is the open circuit voltage $U_{oc}$. The $U_{oc}$ depends on the state of charge, temperature and operating phases (charge or discharge).

The at least one parameter corresponding to a percentage of an initial state of charge of the battery (1) is provided by the NVPF-HC model module 10 to the SOC module 12 as an input parameter.

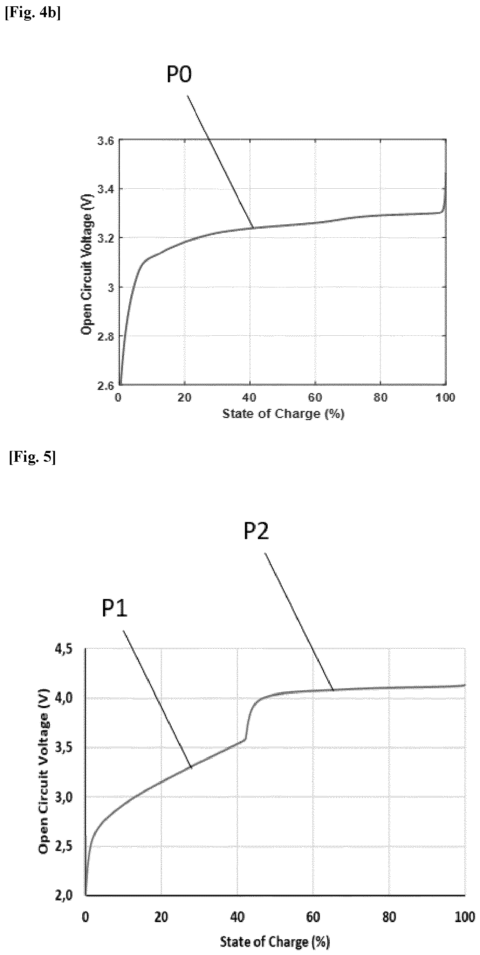

As presented in the figures 4 a and b, the open circuit voltage of the lithium-ion presents a linear function that presents only one stable plateau P0. This plateau P0 is linear in case of NMC (figure 4a), and stable in case of LFP (figure 4b). The open circuit voltage configuration of lithium-ion helps to present the open circuit voltage evolution using some hypothesis. The following hypothesis used generally for lithium-ion cells:

- $$\dot{U}_{OC} = 0$$
-

$$U_{OC}(SOC) = a . SOC + b$$

This hypothesis cannot be applied for the embodiment of sodium-ion NVPF-HC. For sodium-ion NVPF-HC, the open circuit voltage evolution is not linear, as we see in Fig. 5. The open circuit voltage evolution contains two stable plateaus P1 and P2: first one P1 from 0 to 40% of state of charge and the second one P2 from 40% to 100% of state of charge. Therefore, a first zone is set to 0 to 3.5 volts (0 to 40 %) and a second zone is set to 3.5 V to 4.5 V (40% to 100%).

The OCV-SOC function is defined based on zones where characteristics are closed to linear (approximation). For NVPF-HC cells, the open circuit voltage depends on the state of charge and the temperature. The two OCV-SOC functions (corresponding to the P1 and P2 zones), corresponding to the two zones which are defined as follows:

$$\{U_{OC}(SOC) = a_1 . SOC + b_1 \ if \ SOC \leq 40\%$$

$$U_{OC}(SOC) = a_2.SOC + b_2 \ if \ SOC > 40\%$$

This subdivision of OCV-SOC function depending on the state of charge interval that can be applied for all the active materials with different plateaus.

The system's measurable states are the cell voltage Vcell, the current i, the cell surface temperature Tcell, and the operating temperature Tamb.

According to the method, from the percentage of the initial state of charge providing by the NVPF-HC model module 10 and from at least two distinct models, at least one estimation of a state of charge and at least one output voltage value are calculated. The two calculations are made from at least two distinct models. The calculations of the at least two models are realized in parallel, at the same time.

In the presented embodiment, the first model consists of a state of charge estimation using an observer and more particularly, an extended Kalman observer. For the state of charge estimation for NVPF-HC sodium-ion cells, the state functions are:

$$SOC_k = SOC_{k-1} + \frac{\eta.dt}{Q}.i_k$$

$$SOC_k = \begin{bmatrix} 1 & \dfrac{\eta.dt}{Q} \end{bmatrix} \begin{bmatrix} SOC_{k-1} \\ i_k \end{bmatrix}$$

$$V_{surf,k} = \alpha.V_{surf,k-1} - \beta.i_k$$

$$V_{surf,k} = \begin{bmatrix} \alpha & -\beta \end{bmatrix} \begin{bmatrix} V_{surf,k-1} \\ i_k \end{bmatrix}$$

With $\alpha = \dfrac{R_{surf}.C_{surf}}{dt - R_{surf}.C_{surf}}$ and $\beta = \dfrac{R_{surf}.dt}{dt - R_{surf}.C_{surf}}$

Based on the state functions, the state vector for the Kalman observer is $X = \begin{bmatrix} SOC \\ V_2 \end{bmatrix}$ where $V_2 = V_{surf} + V_d$

$Y_k = V_k$ is the output,

It is assumed that noise is white, Gaussian. In fact, this model must combine all deterministic system information and the system's variables are continuous. In the model of the present invention, the main goal of this extended Kalman is to estimate the state of charge characterization. The parameters to be estimated by the observer along with the input and output Y are as follows :

$$\text{Considering } X = \begin{bmatrix} SOC \\ V_{surf} \end{bmatrix}$$

$$\text{So } X_{k+1} = A.X_k + B.i_k, \text{ Where } A = \begin{bmatrix} 1 & \alpha \end{bmatrix} \text{ and } B = \begin{bmatrix} \dfrac{\eta.dt}{Q} & -\beta \end{bmatrix}$$

The input is the current $i_k$. And the output $Y_k = V_k = a.SOC_k + b + V_{surf,k} + R.i_k$

$$Y_k = \begin{bmatrix} a & 1 \end{bmatrix}.X_k + R.i_k + b$$

where D=[a 1]

If $SOC \leq 40\%$, $a = a_1$ and $b = b_1$
If $SOC > 40\%$, $a = a_2$ and $b = b_2$

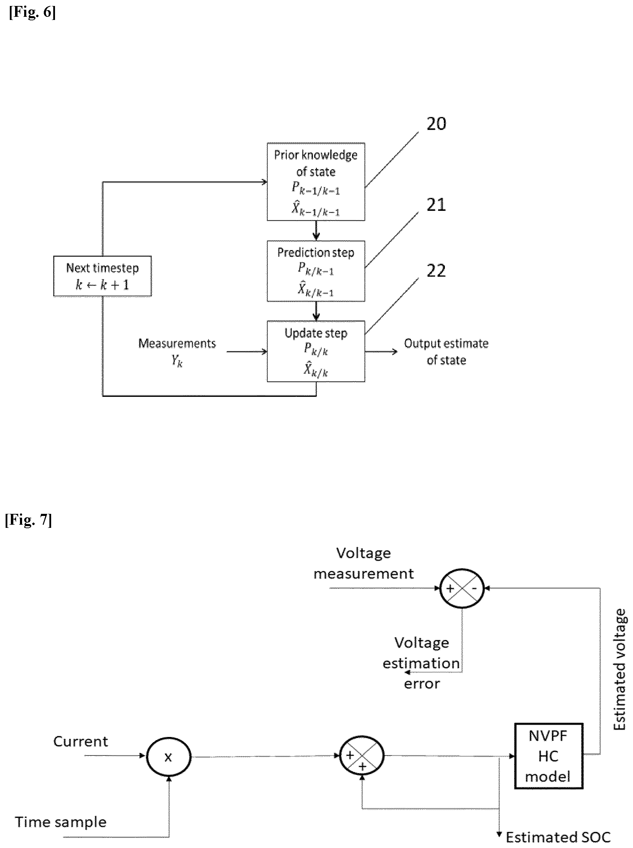

For the estimation model using Kalman filter, the model estimates or predict 21 the state of charge 2. All the details of the Kalman filter model are presented in figure 6. The Kalman filter in discrete context is a recursive estimator. This means that to predict 21 the current state, only the estimation of the previous state 20 and current measurements are needed. Historical observations and predictions are therefore not required. The initial state of health is an input data to the model. The model outputs an estimation of the state of charge. From the estimation of the state of charge, an output voltage is calculated. The model repeats said steps at each timestep or iteration. Therefore, the values of the state-of-charge estimation and the output voltage are updated 22 at each iteration.

The state of the observer is represented by two variables:

$\hat{X}_{k-1/k-1}$: the state estimate at time k

$P_{k-1/k-1}$: the error covariance matrix (a measure of the accuracy of the estimated state).

The Kalman filter has two distinct phases: prediction 20 and update 21. The prediction step 21 uses the estimated state of the previous instant to produce an estimation of the current state. In the update step 22, the observations of the current time are used to correct the predicted state to obtain a more precise estimation. In other embodiments, the first model consists of a state of charge estimation using a sliding mode observer or an adaptive observer or a fuzzy observer.

In addition to the first model, a second estimation and a second output voltage are calculated in parallel of the first model via a second model. In the presented embodiment, the second model uses a Coulomb counting model. The model of the coulomb counting is presented in figure 7.

Concerning the Coulomb counting model, the model calculates the number of coulomb that charge/discharge the battery. The amount of charge transferred by the current is measured in Coulombs and is given by :

$$C_c = i \times \mathrm{d}t$$

Where $C_c$ is the quantity of charge transferred and dt is the time in seconds that the current flows.

To obtain the state of charge transferred during dt, this calculated charge quantity is compared to the total capacity of the cell considering the coulomb coefficient $\eta$. The sum of the transferred SOC at each iteration gives the total SOC:

$$SOC_k = SOC_{k-1} + \frac{\eta.\,dt}{Q}.\,i_k$$

The same inputs of the Kalman filter are considered in the Coulomb counting model, such as the current and the voltage measurement.

Therefore, the output of the second model is also an estimation of the state of charge and an output voltage 3. From the output voltage of each model, an error rate is calculated. The error rate is calculated by comparing the output voltage of the model and a measured output voltage. When the two error rates are calculated, one error rate per output voltage, they are compared 4 with each other. The estimation of the state of charge that have the lowest error rate corresponding to the state of charge of the battery.

Typically at least one of the means of the device according to the invention described above, preferably each of the means of the device according to the invention described above are technical means.

Typically, each of the means of the device according to the invention described above may comprise at least one computer, a central or computing unit, an analog electronic circuit (preferably dedicated), a digital electronic circuit (preferably dedicated), and / or a microprocessor (preferably dedicated), and / or software means.

Of course, the invention is not limited to the examples just described and many adjustments can be made to these examples without going beyond the scope of the invention.

Of course, the different features, forms, variants and embodiments of the invention can be associated with each other in various combinations to the extent that they are not incompatible or exclusive of each other. In particular, all the variants and embodiments described above are combinable with each other.

**Claims**

1. Method for determining a state of charge (SOC) of a battery, the method comprising the following steps:

   - receiving at least one parameter corresponding to a percentage of an initial state of charge of the battery (1) based on at least one off-load voltage value and according to an open circuit voltage (OCV) - state of charge (SOC) function pace zone, the OCV-SOC function pace being separated into at least two zones,
   - based on the at least one received parameter and at least two distinct models, determining for each model (2 and 3), at least one estimation of a state of charge and at least one output voltage value,- providing an estimation of the state of charge of the battery based on the determined state of charge having the lowest error rate (4).

2. Method according to claim 1, wherein the step of receiving at least one parameter comprises the following steps :

   - receiving at least one off-load voltage value,
   - partitioning of the OCV-SOC function in at least two zones, each zone having a distinct function,
   - determining to which zone the at least one off-load voltage value belongs,
   - providing the percentage of an initial state of charge of the battery from the function according to the said zone.

3. Method according to any one of claims 1 to 2, wherein for the at least two zones of the OCV-SOC function, a first zone is set to 0 to 3.5 volts and a second zone is set to 3.5 V to 4.5 volts.

4. Method according to claim 1, wherein the first of the at least two distinct models use an observer.

5. Method according to claim 4, wherein the used observer is a Kalman filter.

6. Method according to claim 1, wherein the first of the at least two distinct models use a sliding mode observer.

7. Method according to claim 1, wherein the first of the at least two distinct models use an adaptive observer.

8. Method according to any one of claims 1 to 7, wherein the second of the at least two distinct models use a counting function.

9. Method according to claim 8, wherein the used counting function is a coulomb counting.

10. Method according to any one of claims 1 to 8, wherein the state of charge is updated at each iteration of the at least two models.

11. System for determining a state of charge (SOC) of a battery, the system comprising:

   - a calculation module,
   - one or more processors;
   - one or more computer-readable media storing instructions that, when executed by the one or more processors, cause the system to:
   - receive at least one parameter corresponding to a percentage of an initial state of charge of the battery (1) based on at least one off-load voltage value and according to an open circuit voltage (OCV) function - state of charge (SOC) pace zone, the OCV-SOC function pace being separated into at least two zones,
   - based on the at least one received parameter and at least two distinct models, determine for each model (2 and 3), at least one estimation of a state of charge and at least one output voltage value,
   - provide an estimation of the state of charge of the battery based on the determined state of charge having the lowest error rate (4).

12. System according to claim 11, wherein the one or more computer-readable media are configured to:

   - receive at least one off-load voltage value,
   - cut of the OCV-SOC function in at least two zones, each zone having a distinct function,
   - determine to which zone the at least one off-load voltage value belongs,
   - provide the percentage of an initial state of charge of the battery from the function according to the said zone.

13. System according to any one of claims 11 to 12, wherein for the at least two zones of the OCV-SOC function, a first zone is set to 0 to 3.5 volts and a second zone is set to 3.5 V to 4.5 volts.

14. System according to claim 11, wherein the first of the at least two distinct models use an observer.

15. System according to claim 14, wherein the used observer is a Kalman filter.

16. System according to claim 11, wherein the first of the at least two distinct models use a sliding mode observer.

17. System according to claim 11, wherein the first of the at least two distinct models use an adaptive observer.

18. System according to any one of claims 11 to 17, wherein the second of the at least two distinct models use a counting function.

19. System according to claim 18, wherein the used counting function is a coulomb counting.

20. System according to any one of claims 11 to 19, wherein the one or more computer-readable media are configured to update the state of charge at each iteration of the at least two models.

21. One or more non-transitory computer-readable media storing instructions that, when executed by one or more processors, cause a system to execute a method for determining a state of charge (SOC) of a battery, comprising the following steps:

    - receiving at least one parameter corresponding to a percentage of an initial state of charge of the battery (1) based on at least one off-load voltage value and according to an open circuit voltage (OCV) - state of charge (SOC) function pace zone, the OCV-SOC function pace being separated into at least two zones,
    - based on the at least one received parameter and at least two distinct models, determining for each model (2 and 3), at least one estimation of a state of charge and at least one output voltage value,
    - providing an estimation of the state of charge of the battery based on the determined state of charge having the lowest error rate (4).

[Fig. 1]

[Fig. 2]

[Fig. 3]

[Fig. 4a]

[Fig. 4b]

[Fig. 5]

[Fig. 6]

[Fig. 7]

[Fig. 8a]

[Fig. 8b]

Europäisches
Patentamt

European
Patent Office

Office européen
des brevets

# EUROPEAN SEARCH REPORT

**Application Number**

**EP 22 30 6370**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PEREZ G ET AL: "Modelling of Li-ion batteries dynamics using impedance spectroscopy and pulse fitting: EVs application", 2013 WORLD ELECTRIC VEHICLE SYMPOSIUM AND EXHIBITION (EVS27), IEEE, 17 November 2013 (2013-11-17), pages 1-9, XP032654100, DOI: 10.1109/EVS.2013.6914973 [retrieved on 2014-10-01] | 1,3-11, 13-21 | INV. G01R31/367 |
| A | * Figures 1 and 5 and corresponding text * ----- | 2,12 | |
| A | RAHIMIFARD SARA ET AL: "Interacting Multiple Model Strategy for Electric Vehicle Batteries State of Charge/Health/ Power Estimation", IEEE ACCESS, IEEE, USA, vol. 9, 5 August 2021 (2021-08-05), pages 109875-109888, XP011871150, DOI: 10.1109/ACCESS.2021.3102607 [retrieved on 2021-08-09] * the whole document * ----- | 1-21 | |
| A | US 2015/046108 A1 (AKAMINE NAOSHI [JP]) 12 February 2015 (2015-02-12) * paragraphs [0003], [0004], [0046], [0090]; figure 2 * ----- | 1-21 | |
| A | KIM ET AL: "The novel state of charge estimation method for lithium battery using sliding mode observer", JOURNAL OF POWER SOURCES, ELSEVIER, AMSTERDAM, NL, vol. 163, no. 1, 4 January 2007 (2007-01-04), pages 584-590, XP005738383, ISSN: 0378-7753, DOI: 10.1016/J.JPOWSOUR.2006.09.006 * the whole document * ----- | 1-21 | |

**TECHNICAL FIELDS SEARCHED (IPC)**

G01R

The present search report has been drawn up for all claims

| Place of search | Date of completion of the search | Examiner |
|---|---|---|
| Munich | 8 March 2023 | O'Callaghan, D |

EPO FORM 1503 03.82 (P04C01)

## ANNEX TO THE EUROPEAN SEARCH REPORT
## ON EUROPEAN PATENT APPLICATION NO.

EP 22 30 6370

This annex lists the patent family members relating to the patent documents cited in the above-mentioned European search report.
The members are as contained in the European Patent Office EDP file on
The European Patent Office is in no way liable for these particulars which are merely given for the purpose of information.

08-03-2023

| Patent document cited in search report | | Publication date | Patent family member(s) | | Publication date |
|---|---|---|---|---|---|
| US 2015046108 | A1 | 12-02-2015 | JP | 5798067 B2 | 21-10-2015 |
| | | | JP | 2013190274 A | 26-09-2013 |
| | | | US | 2015046108 A1 | 12-02-2015 |
| | | | WO | 2013136559 A1 | 19-09-2013 |

EPO FORM P0459

For more details about this annex : see Official Journal of the European Patent Office, No. 12/82